# EUROPEAN PATENT APPLICATION

(11) **EP 4 683 215 A1**
(43) Date of publication of application: **21.01.2026**
(21) Application number: 24777509.1
(22) Date of filing: 01.02.2024
(51) Int. Cl.: H03B 19/14

(54) **FREQUENCY MULTIPLIER AND WIRELESS COMMUNICATION DEVICE**

(30) Priority: 29.03.2023 CN 202310351681
(71) Applicant: Huawei Technologies Co., Ltd., Shenzhen, Guangdong 518129 (CN)
(72) Inventor: GAO, Hao, 5600MB Eindhoven (NL); FANG, Yun, 5600MB Eindhoven (NL); HUEBER, Gernot, 4040 Linz (AT); AI, Chao, Shenzhen, Guangdong 518129 (CN); ZHAI, Liqian, Shenzhen, Guangdong 518129 (CN)
(74) Representative: Goddar, Heinz J.
(86) International application number: PCT/CN2024/075337
(87) International publication number: WO 2024/198715

(57) **Abstract**

This application provides a frequency multiplier, including an oscillator and a harmonic generator. The oscillator includes a resonant cavity and a negative resistance unit. The harmonic generator is configured to generate a harmonic signal based on an input fundamental frequency signal. The oscillator is electrically connected to the harmonic generator, and is configured to receive the harmonic signal, and output an intrinsic signal by using the resonant cavity. A frequency of the intrinsic signal is a multiple of a frequency of the fundamental frequency signal. The negative resistance unit includes a feedback capacitor and a parasitic capacitor. The feedback capacitor and the parasitic capacitor collectively provide negative resistance for the resonant cavity. This application further provides a wireless communication device. Therefore, according to the frequency multiplier and the wireless communication device provided in this application, energy efficiency of the frequency multiplier may be improved, thereby optimizing a balance between bandwidth, energy efficiency, and power consumption of the frequency multiplier.

## Description

### CROSS-REFERENCE TO RELATED APPLICATIONS

This application claims priority to Chinese Patent Application No. 202310351681.5, filed with the China National Intellectual Property Administration on March 29, 2023 and entitled "FREQUENCY MULTIPLIER AND WIRELESS COMMUNICATION DEVICE", which is incorporated herein by reference in its entirety.

### TECHNICAL FIELD

This application relates to the field of circuit technologies, and in particular, to a frequency multiplier and a wireless communication device.

### BACKGROUND

With development of wireless communication technologies, frequency multipliers are applied more widely. A frequency multiplier is generally used to multiply a frequency of an input signal, so that a frequency of an output signal is a multiple of the frequency of the input signal, to generate a high-frequency carrier for signal modulation. However, it is difficult to balance bandwidth, energy efficiency, and power consumption of the frequency multiplier.

### SUMMARY

In view of the foregoing problem, this application provides a frequency multiplier and a wireless communication device, to improve energy efficiency of the frequency multiplier, thereby optimizing a balance between bandwidth, energy efficiency, and power consumption of the frequency multiplier.

According to a first aspect, this application provides a frequency multiplier, including an oscillator and a harmonic generator. The oscillator includes a resonant cavity and a negative resistance unit. The harmonic generator is configured to generate a harmonic signal based on an input fundamental frequency signal. The oscillator is electrically connected to the harmonic generator, and is configured to receive the harmonic signal, and output an intrinsic signal by using the resonant cavity. A frequency of the intrinsic signal is a multiple of a frequency of the fundamental frequency signal. The negative resistance unit includes a feedback capacitor and a parasitic capacitor. The feedback capacitor and the parasitic capacitor collectively provide negative resistance for the resonant cavity. According to the frequency multiplier provided in this application, the negative resistance unit may be formed by using the feedback capacitor and the parasitic capacitor. In this way, an energy loss of the resonant cavity in the oscillator may be supplemented, thereby improving energy efficiency of the frequency multiplier and optimizing a balance between bandwidth, energy efficiency, and power consumption of the frequency multiplier.

With reference to the first aspect, in a possible implementation, the harmonic signal includes a plurality of harmonic components. A frequency of each of the plurality of harmonic components is a multiple of the frequency of the fundamental frequency signal. Outputting the intrinsic signal by using the resonant cavity includes: The resonant cavity performs resonant amplification on one of the plurality of harmonic components, to obtain the intrinsic signal. According to the frequency multiplier provided in this application, harmonic components based on the frequency of the fundamental frequency signal may be generated by using a non-linear device, and then one frequency of the harmonic components is amplified by using the resonant cavity, to obtain the required intrinsic signal.

With reference to the first aspect, in a possible implementation, the oscillator further includes a first transistor and a second transistor. The first transistor and the second transistor are configured to receive the harmonic signal. A gate of the first transistor is coupled to a source of the second transistor by using a first capacitor. A gate of the second transistor is coupled to a source of the first transistor by using a second capacitor. According to the frequency multiplier provided in this application, two cross-coupled switching transistors may be disposed as switching transistors for receiving the harmonic signal, so that the negative resistance of the resonant cavity may be further provided by the two cross-coupled switching transistors. In this way, vibration difficulty of the resonant cavity is reduced, output power of the intrinsic signal is improved, and common-mode interference is further reduced, thereby reducing noise of the intrinsic signal and improving signal quality of the intrinsic signal.

With reference to the first aspect, in a possible implementation, the frequency multiplier further includes an inductor. The inductor is electrically connected between the harmonic generator and the oscillator. In this application, the inductor is disposed between the oscillator and the harmonic generator, to increase a voltage of the harmonic signal, thereby further increasing bandwidth of the frequency multiplier.

With reference to the first aspect, in a possible implementation, there are two feedback capacitors. One of the two feedback capacitors is electrically connected between the source of the first transistor and a drain of the first transistor. The other feedback capacitor is electrically connected between the source of the second transistor and a drain of the second transistor.

With reference to the first aspect, in a possible implementation, there are two parasitic capacitors. One of the two parasitic capacitors is electrically connected between the source of the first transistor and a ground. The other parasitic capacitor is electrically connected between the source of the second transistor and the ground.

With reference to the first aspect, in a possible implementation, the harmonic generator includes a third transistor, the fundamental frequency signal includes a first fundamental frequency signal, and the harmonic signal includes a first harmonic signal. The third transistor is configured to generate the first harmonic signal based on the first fundamental frequency signal. The first harmonic signal includes a plurality of harmonic components. A frequency of each of the plurality of harmonic components is a multiple of the frequency of the fundamental frequency signal.

With reference to the first aspect, in a possible implementation, there are two inductors, the harmonic generator further includes a fourth transistor, and the fundamental frequency signal further includes a second fundamental frequency signal. A gate of the third transistor receives the first fundamental frequency signal by using a third capacitor. A source of the third transistor is grounded. A drain of the third transistor is electrically connected to the source of the first transistor by using one of the inductors. A gate of the fourth transistor receives the second fundamental frequency signal by using the third capacitor. A source of the fourth transistor is grounded. The drain of the third transistor is electrically connected to the source of the second transistor by using the other inductor. The first fundamental frequency signal and the second fundamental frequency signal are differential signals of each other. In the frequency multiplier provided in this application, the harmonic generator receives the fundamental frequency signal by using a structure of a differential switching transistor pair, thereby suppressing common-mode interference and improving signal quality of the intrinsic signal.

With reference to the first aspect, in a possible implementation, when the third transistor is conducted, the gate of the second transistor receives the first harmonic signal by using the second capacitor and outputs the intrinsic signal by using the resonant cavity. When the third transistor is cut off, the second transistor is cut off, and stops outputting the intrinsic signal by using the resonant cavity. According to the frequency multiplier provided in this application, the oscillator separately generates a first intrinsic signal based on the first harmonic signal at a first moment, suppresses the first intrinsic signal at a second moment, and generates a second intrinsic signal based on a second harmonic signal. Common-mode interference is suppressed by using a differential output structure, and the intrinsic signal output by the oscillator depends on an output time sequence of the harmonic signal rather than a frequency of an externally injected signal, thereby reducing a phenomenon of injection locking and improving bandwidth of the oscillator.

According to a second aspect, this application provides a wireless communication device, including a transmitter and/or a receiver. The transmitter or the receiver or both include the frequency multiplier according to any possible implementation of the first aspect and a frequency mixer. The frequency mixer is configured to perform frequency mixing on an input signal and an intrinsic signal that is output by the frequency multiplier.

In addition, for beneficial effects that may be brought by the implementations of the second aspect, refer to beneficial effects brought by corresponding implementations of the first aspect. Details are not described herein.

### BRIEF DESCRIPTION OF DRAWINGS

FIG. 1 is a diagram of a structure of a frequency multiplier;
FIG. 2 is a diagram of a structure of another frequency multiplier;
FIG. 3 is a diagram of a structure of still another frequency multiplier;
FIG. 4 is a block diagram of a structure of a frequency multiplier according to this application;
FIG. 5 is a circuit diagram of a frequency multiplier according to this application; and
FIG. 6 is a diagram of a structure of a wireless communication device according to this application.

### DESCRIPTION OF EMBODIMENTS

The following clearly describes technical solutions in embodiments of this application with reference to the accompanying drawings in embodiments of this application.

It may be understood that a connection relationship described in this application is a direct or indirect connection. For example, that A is connected to B may be that A is directly connected to B, or may be that A is indirectly connected to B by using one or more other electrical components. For example, A may be directly connected to C, and C may be directly connected to B, so that A and B are connected by using C. It may be further understood that "A is connected to B" described in this application may be that A is directly connected to B, or may be that A is indirectly connected to B by using one or more other electrical components.

In descriptions of this application, unless otherwise specified, "/" means "or". For example, A/B may indicate A or B. A term "and/or" in this specification describes only an association relationship between associated objects and indicates that there may be three relationships. For example, A and/or B may represent the following three cases: Only A exists, both A and B exist, and only B exists.

In the descriptions of this application, words such as "first" and "second" are merely used to distinguish between different objects, and do not limit quantities and execution sequences. In addition, the words such as "first" and "second" do not indicate a definite difference. In addition, the terms "include" and "have" and any variations thereof are intended to cover non-exclusive inclusion.

The following further describes the technical solutions of this application in detail with reference to the accompanying drawings.

With development of wireless communication technologies, frequency multipliers are applied more widely. A frequency multiplier is generally used to multiply a frequency of an input signal, so that a frequency of an output signal is a multiple of the frequency of the input signal, to generate a high-frequency carrier for signal modulation. The frequency multiplier generally includes a non-linear device and a frequency converter. The non-linear device is configured to receive a fundamental frequency signal, and generate a plurality of harmonic components of the fundamental frequency signal. The frequency converter performs frequency shifting or frequency screening on the plurality of harmonic components, to output a frequency multiplied signal including a target frequency.

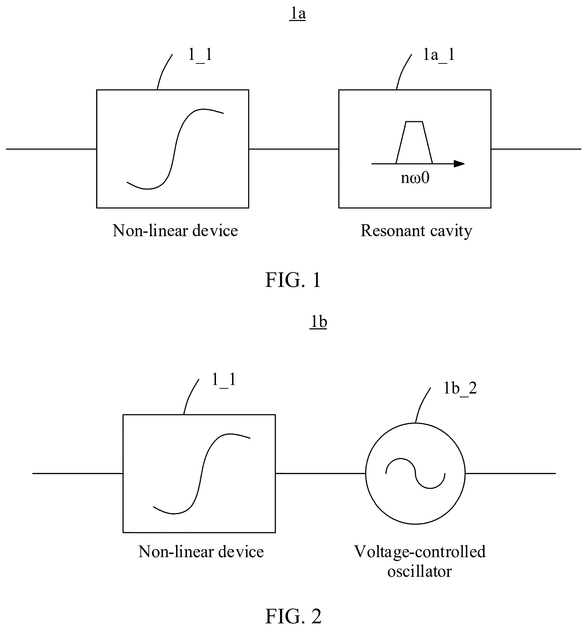

For example, as shown in FIG. 1, a frequency multiplier 1a includes a nonlinear device 1_1 and a resonant cavity 1a_1, where the resonant cavity 1a_1 is a frequency converter. The resonant cavity 1a_1 may screen and amplify, based on a resonance frequency of the resonant cavity 1a_1, a harmonic component that has a same frequency as the resonance frequency in a plurality of harmonic components that are output by the non-linear device 1_1, to output a frequency multiplied signal including the resonance frequency. However, a higher harmonic order indicates lower energy of a corresponding harmonic component. Therefore, when the target frequency is at least three times the frequency of the fundamental frequency signal, in the frequency multiplied signal that is obtained through screening and amplification by using the resonant cavity 1a_1, component power of the target frequency is relatively low and needs to be further amplified by using a multi-level amplifier. As a result, power consumption of the frequency multiplier 1a increases.

For another example, as shown in FIG. 2, a frequency multiplier 1b includes a non-linear device 1_1 and a voltage-controlled oscillator 1b_2, where the voltage-controlled oscillator 1b_2 is a frequency converter. The voltage-controlled oscillator 1b_2 has a phenomenon of injection locking. In other words, when a frequency of an externally injected signal is close to a free-run frequency of the voltage-controlled oscillator 1b_2, a frequency of an output signal of the voltage-controlled oscillator 1b_2 is affected by the externally injected signal, and is locked to the frequency of the externally injected signal. Therefore, the voltage-controlled oscillator 1b_2 may screen a plurality of harmonic components, to obtain a frequency multiplied signal. Specifically, a frequency of the frequency multiplied signal is close to the free-run frequency of the voltage-controlled oscillator 1b_2. However, because the free-run frequency of the voltage-controlled oscillator 1b_2 is monotonous, bandwidth of the frequency multiplied signal output by the voltage-controlled oscillator 1b_2 is relatively small.

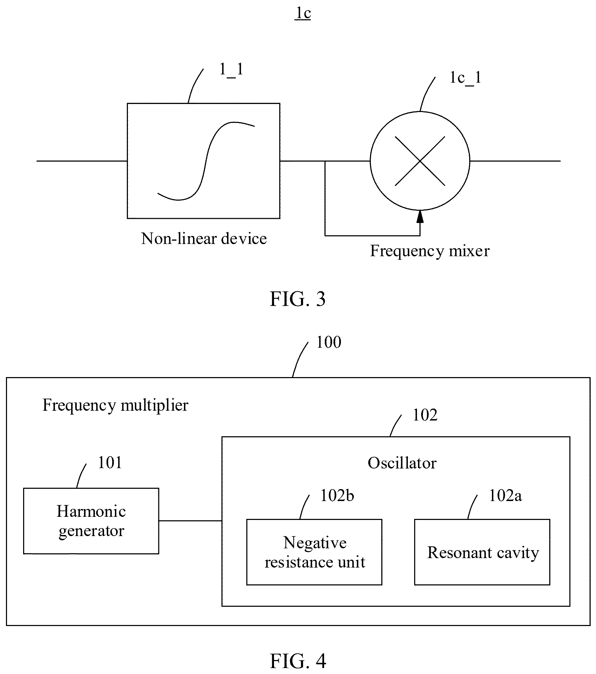

For another example, as shown in FIG. 3, a frequency multiplier 1c includes a non-linear device 1_1 and a frequency mixer 1c_1, where the frequency mixer 1c_1 is a frequency converter. The frequency mixer 1c_1 performs self-mixing on a plurality of harmonic components to perform frequency shifting on the plurality of harmonic components, to obtain a frequency multiplied signal. However, a power supply voltage of the frequency mixer 1c_1 is relatively high, and it is difficult to implement the frequency mixer 1c_1 in an application scenario in which a power supply voltage is low.

Therefore, this application provides a frequency multiplier and a wireless communication device. A feedback capacitor and a parasitic capacitor form a negative resistance unit, to supplement an energy loss of a resonant cavity in an oscillator, thereby improving energy efficiency of the frequency multiplier, and optimizing a balance between bandwidth, energy efficiency, and power consumption of the frequency multiplier.

Refer to FIG. 4. FIG. 4 is a block diagram of a structure of a frequency multiplier 100 according to this application. The frequency multiplier 100 includes a harmonic generator 101 and an oscillator 102. The oscillator 102 includes a resonant cavity 102a and a negative resistance unit 102b.

The harmonic generator 101 is electrically connected to the oscillator 102. The harmonic generator 101 is configured to generate a harmonic signal. Specifically, the harmonic generator 101 includes a non-linear device, so that the harmonic generator 101 may receive a fundamental frequency signal, and generate, based on the fundamental frequency signal, the harmonic signal including a plurality of harmonic components. A frequency of each of the plurality of harmonic components is a multiple of a frequency of the fundamental frequency signal. In this way, the harmonic generator 101 may generate the plurality of harmonic components whose frequencies are multiples of the frequency of the fundamental frequency signal, to obtain the harmonic signal.

The oscillator 102 is configured to receive the harmonic signal, and output an intrinsic signal by using the resonant cavity 102a, where a frequency of the intrinsic signal is a multiple of a frequency of the harmonic signal. Specifically, the resonant cavity 102a may screen and amplify a harmonic component that has a same frequency as a resonance frequency of the resonant cavity 102a in the harmonic signal, to output the intrinsic signal including the resonance frequency. The resonance frequency of the resonant cavity 102a may be adjusted by adjusting impedance of the resonant cavity 102a. A harmonic component including a target frequency may be selected and output as the intrinsic signal by adjusting the resonance frequency of the resonant cavity 102a.

The negative resistance unit 102b is electrically connected to the resonant cavity 102a. The negative resistance unit 102b is configured to provide negative resistance for the resonant cavity 102a. The negative resistance means an electronic component or a circuit module whose total impedance exhibits negative resistance. Mutual conversion of electromagnetic energy exists in the resonant cavity 102a, and energy conversion efficiency of the resonant cavity 102a is not persistently 100%, that is, an energy loss is inevitably caused in a working process of the resonant cavity 102a. Therefore, if lost energy is not supplemented in a timely manner, resonance of the resonant cavity 102a cannot be sustained. As a result, a strength of the intrinsic signal output by the resonant cavity 102a gradually attenuates, and the frequency multiplier 100 cannot work normally. However, the negative resistance unit 102b has a negative resistance characteristic, that is, the negative resistance unit 102b is an active device and can output energy to the outside. Therefore, the negative resistance unit 102b may be configured to provide negative resistance for the resonant cavity 102a, that is, the negative resistance unit 102b may supplement the energy lost by the resonant cavity 102a in the resonance process, to ensure stable resonance of the resonant cavity 102a, thereby ensuring normal running of the frequency multiplier 100.

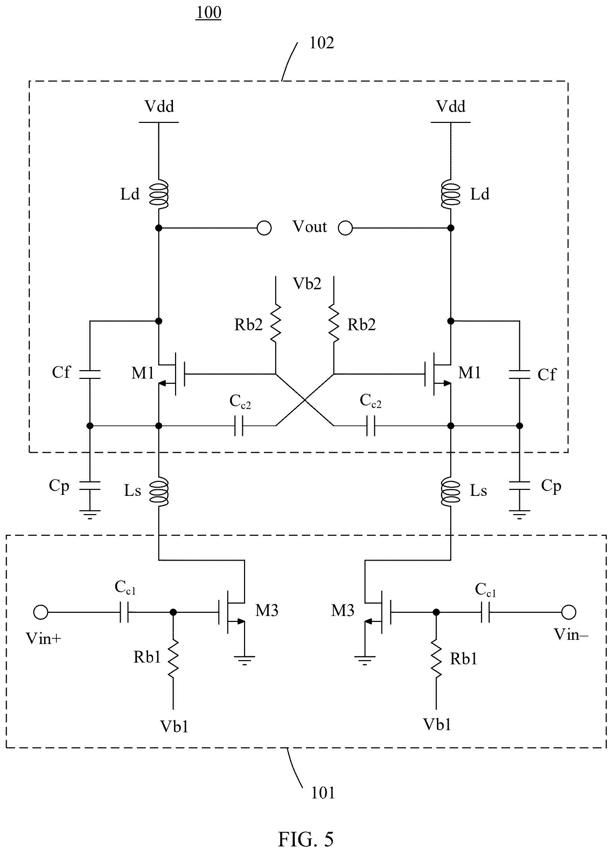

Refer to FIG. 5. FIG. 5 is a circuit diagram of a frequency multiplier 100 according to this application. The frequency multiplier 100 includes a harmonic generator 101, an oscillator 102, and an inductor Ls. The oscillator 102 includes a resonant cavity 102a, a negative resistance unit 102b, a switching transistor M1, a switching transistor M2, a coupling capacitor Cc2, and a bias resistor Rb2. The negative resistance unit 102b includes a feedback capacitor Cf and a parasitic capacitor Cp. The resonant cavity 102a includes an inductor Ld. The harmonic generator 101 includes a switching transistor M3, a switching transistor M4, a coupling capacitor Cc1, and a bias resistor Rb1.

In this embodiment, description is given by using an example in which all of the switching transistors are NMOS transistors. In some other embodiments, the switching transistor may alternatively be a semiconductor switching element, such as a PMOS transistor, a triode, or a controlled switch.

The harmonic generator 101 includes the switching transistor M3 and the switching transistor M4 that form a differential symmetric structure. A gate of the switching transistor M3 is electrically connected to one end of the coupling capacitor Cc1 and one end of the bias resistor Rb1. The other end of the coupling capacitor Ccl receives a first fundamental frequency signal from a first input end Vin+, and the other end of the bias resistor Rb1 receives a first bias voltage Vbl. The bias voltage Vb1 provides a direct current bias voltage of the switching transistor M3, so that the switching transistor M3 operates at a critical conduction point. A source of the switching transistor M3 is grounded, and a drain of the switching transistor M3 is electrically connected to one end of the inductor Ls. A gate of the switching transistor M4 is electrically connected to one end of the coupling capacitor Cc1 and one end of the bias resistor Rb1. The other end of the coupling capacitor Cc1 receives a second fundamental frequency signal from a second input end Vin-, and the other end of the bias resistor Rb1 receives the first bias voltage Vb1. The bias voltage Vb1 provides a direct current bias voltage of the switching transistor M4, so that the switching transistor M4 operates at a critical conduction point. The source of the switching transistor M3 is grounded, and the drain of the switching transistor M3 is electrically connected to one end of the inductor Ls.

It may be understood that, in the harmonic generator 101, a connection relationship between the switching transistor M4 and another electronic element (for example, the coupling capacitor Cc1, the bias resistor Rb1, and the inductor Ls) is the same as a connection relationship between the switching transistor M3 and a corresponding electronic element. Two switching transistors having a mutually differential symmetric structure are disposed, and a differentially output harmonic signal is generated based on a differentially input fundamental frequency signal by using a non-linear feature of the switching transistors. In this way, a non-target-order harmonic component (for example, a second-order harmonic) caused by common-mode interference in the harmonic signal may be suppressed, thereby reducing noise of an intrinsic signal and improving signal quality of the intrinsic signal.

Corresponding to the harmonic generator 101, the oscillator 102 includes a switching transistor M1 and a switching transistor M2 that also form a differential symmetric structure. A source of the switching transistor M1 is electrically connected to one end of one coupling capacitor Cc2, the other end of the inductor Ls, one end of the parasitic capacitor Cp, and one end of the feedback capacitor Cf. A drain of the switching transistor M1 is connected to the other end of the feedback capacitor Cf, one end of the inductor Ld, and a first output end of the oscillator 102. A gate of the switching transistor M1 is electrically connected to one end of the bias resistor Rb2 and one end of another coupling capacitor Cc2. The other end of the bias resistor Rb2 receives a bias voltage Vb2. The bias voltage Vb2 provides a direct current bias voltage of the switching transistor M1 and the switching transistor M2, so that the switching transistor M1 and the switching transistor M2 work at a critical conduction point.

It may be understood that, in the oscillator 102, a connection relationship between the switching transistor M2 and another electronic element (for example, the coupling capacitor Cc2, the bias resistor Rb2, the inductor Ls, the feedback capacitor Cf, and the parasitic capacitor Cp) is the same as a connection relationship between the switching transistor M1 and a corresponding electronic element. In addition, the switching transistor M1 and the switching transistor M2 form a cross-coupled structure. In other words, the drain of the switching transistor M1 is connected to a gate of the switching transistor M2 by using the feedback capacitor Cf and the coupling capacitor Cc2, and a drain of the switching transistor M2 is connected to the gate of the switching transistor M1 by using another feedback capacitor Cf and another coupling capacitor Cc2. Two cross-coupled switching transistors are disposed as switching transistors of the oscillator 102 for receiving the harmonic signal, so that the negative resistance of the resonant cavity 102a may be further provided by the cross-coupled switching transistors M1 and M2. In this way, vibration difficulty of the resonant cavity 102a is reduced, output power of the intrinsic signal is improved, and common-mode interference is further reduced, to reduce noise of the intrinsic signal and improve signal quality of the intrinsic signal.

In the oscillator 102, one end of the inductor Ld in the resonant cavity 102a receives a preset voltage Vdd, and the other end is connected to an output end corresponding to the oscillator 102. For example, the inductor Ld connected to the drain of the switching transistor M1 is further connected to a first output end, and the inductor Ld connected to the drain of the switching transistor M2 is further connected to a second output end. An output signal of the first output end is a first intrinsic signal, and an output signal of the second output end is a second intrinsic signal. The first intrinsic signal and the second intrinsic signal are differential signals of each other. The first intrinsic signal and the second intrinsic signal may be combined into the intrinsic signal.

In this embodiment, the oscillator 102 includes a Colpitts (Colpitts) oscillator circuit that is disposed in a differential manner. In some other embodiments, the oscillator 102 may include a Hartley (Hartley) oscillator circuit.

The following describes, with reference to the circuit structure shown in FIG. 5, a working procedure of the frequency multiplier 100 provided in this application.

First, the switching transistor M3 receives the first fundamental frequency signal by using the corresponding coupling capacitor Cc1, and the switching transistor M4 receives the second fundamental frequency signal by using the corresponding coupling capacitor Cc1. The first fundamental frequency signal and the second fundamental frequency signal are two differential signal components of the fundamental frequency signal. At a first moment, controlled by the bias voltage Vbl, the switching transistor M3 is conducted; and a first harmonic signal is generated based on the non-linear feature. The first harmonic signal includes a plurality of harmonic components, and a frequency of each harmonic component varies. The frequency of each harmonic component is a multiple of a frequency of the first fundamental frequency signal. Correspondingly, the first fundamental frequency signal and the second fundamental frequency signal are differential signals of each other, that is, the switching transistor M3 and the switching transistor M4 are alternately conducted and cut off. Therefore, at a second moment, the switching transistor M3 is cut off, and stops outputting the first harmonic signal; and the switching transistor M4 is conducted, and outputs a second harmonic signal. It may be understood that the first harmonic signal and the second harmonic signal are two differential signal components of the harmonic signal. In this way, the oscillator 102 separately generates the first intrinsic signal at the first moment based on the first harmonic signal, suppresses the first intrinsic signal at the second moment, and generates the second intrinsic signal based on the second harmonic signal. Common-mode interference is suppressed by using a differential output structure, and the intrinsic signal output by the oscillator 102 depends on an output time sequence of the harmonic signal rather than a frequency of an externally injected signal, thereby reducing the phenomenon of injection locking and improving bandwidth of the oscillator 102.

Then, the first harmonic signal is transmitted to the gate of the switching transistor M1 by using the corresponding inductor Ls and the corresponding coupling capacitor Cc2; and the second harmonic signal is transmitted to the gate of the switching transistor M2 by using the corresponding inductor Ls and the corresponding coupling capacitor Cc2. Herein, the inductor Ls may increase a voltage amplitude of the harmonic signal, thereby increasing bandwidth of the frequency multiplier 100.

Then, at a third moment, controlled by the bias voltage Vb2, the switching transistor M1 is conducted, and the first harmonic signal is amplified and then transmitted to the inductor Ld of the resonant cavity 102a. The resonant cavity 102a further performs resonance amplification on the amplified first harmonic signal based on the resonance frequency that is determined by an inductance value of the inductor Ld, to obtain the first intrinsic signal. Correspondingly, the first harmonic signal and the second harmonic signal are differential signals of each other, that is, the switching transistor M1 and the switching transistor M2 are alternately conducted and cut off. Therefore, at the second moment, the switching transistor M1 is cut off, and stops outputting the first intrinsic signal; and the switching transistor M2 is conducted, and outputs the second intrinsic signal. It may be understood that the first intrinsic signal and the second intrinsic signal are two differential signal components of the intrinsic signal.

In this case, because the resonant cavity 102a continuously oscillates, the feedback capacitor Cf and the parasitic capacitor Cp in the negative resistance unit 102b continuously switch between a charging state and a discharging state, to supplement energy consumed for the oscillation of the resonant cavity 102a. In comparison with a current situation in which negative resistance is provided by using a cross-coupled differential pair of transistors, in this application, a separate negative resistance unit 102b is disposed to provide negative resistance for the resonant cavity 102a, thereby reducing power consumption of the frequency multiplier 100 and improving energy efficiency.

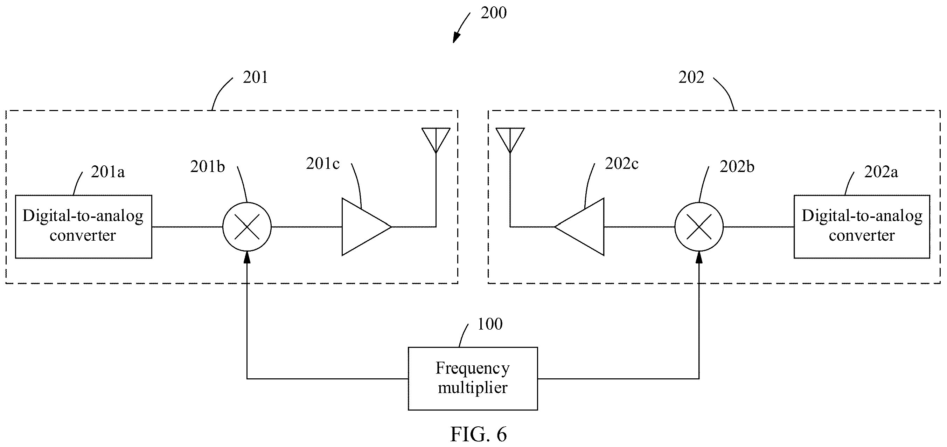

FIG. 6 is a diagram of a structure of a wireless communication device 200 according to this application. The wireless communication device 200 includes a transmitter 201 and a receiver 202. The transmitter 201 is configured to transmit a radio signal, and the receiver 202 is configured to receive the radio signal. Specifically, the transmitter 201 includes a digital-to-analog converter 201a, a frequency mixer 201b, an amplifier 201c, and a frequency multiplier 100 provided in this application. The digital-to-analog converter 201a is configured to convert a digital baseband signal into an analog baseband signal. The digital baseband signal may be generated by a baseband chip, and the digital baseband signal carries to-be-transmitted data. The analog baseband signal is a low-frequency signal. The frequency mixer 201b is electrically connected to the digital-to-analog converter 201a and the frequency multiplier 100. The frequency mixer 201b is configured to perform frequency shifting on the analog baseband signal, that is, perform frequency mixing on the analog baseband signal and the intrinsic signal, so that a frequency of the analog baseband signal is shifted from a low frequency to a high frequency, to obtain a radio frequency signal suitable for radio channel transmission. The intrinsic signal is generated by the frequency multiplier 100. The amplifier 201c is configured to amplify the radio frequency signal, and then transmit the amplified radio frequency signal to free space by using an antenna structure. Correspondingly, the receiver 202 includes an analog-to-digital converter 202a, a frequency mixer 202b, an amplifier 202c, and a frequency multiplier 100 provided in this application. The receiver 202 receives the radio signal by using an antenna, amplifies the radio signal by using the amplifier 202c, demodulates the received high-frequency radio signal into the low-frequency analog baseband signal by using the frequency mixer 202b, and finally converts the analog baseband signal into the digital baseband signal by using the digital-to-analog converter 201a, for the baseband chip to perform signal analysis and data parsing.

Therefore, according to the frequency multiplier and the wireless communication device provided in this application, the separate negative resistance unit 102b is disposed, to provide negative resistance for the resonant cavity 102a by using the feedback capacitor Cf and the parasitic capacitor Cp. In this way, power consumption of the frequency multiplier 100 may be reduced, and energy efficiency may be improved, thereby optimizing energy efficiency and power consumption of the frequency multiplier 100. In addition, the cross-coupled differential switching transistor pair is disposed in the oscillator 102, so that an energy loss of the resonant cavity 102a may be further supplemented, vibration start difficulty of the circuit is reduced, output power of the intrinsic signal is increased, and a noise harmonic at a non-target order is suppressed. In addition, an input current of the oscillator 102 is provided by the harmonic generator 101, and bandwidth of the intrinsic signal output by the oscillator 102 is related to bandwidth of the harmonic signal of the harmonic generator 101, but not determined by injection locking of an external signal. In this way, a bandwidth range of the frequency multiplier 100 may be optimized. Further, the inductor Ls is disposed between the oscillator 102 and the harmonic generator 101, to increase a voltage of the harmonic signal, thereby further increasing the bandwidth of the frequency multiplier 100.

A person of ordinary skill in the art should understand that the foregoing implementations are merely intended to describe this application but are not intended to limit this application, and all appropriate modifications and changes made to the foregoing embodiments fall within the protection scope of this application provided that the modifications and changes are within the spirit and scope of the essence of this application.

## Claims

1. A frequency multiplier, comprising an oscillator and a harmonic generator, wherein the oscillator comprises a resonant cavity and a negative resistance unit;
the harmonic generator is configured to generate a harmonic signal based on an input fundamental frequency signal;
the oscillator is electrically connected to the harmonic generator, and is configured to receive the harmonic signal, and output an intrinsic signal by using the resonant cavity, wherein a frequency of the intrinsic signal is a multiple of a frequency of the fundamental frequency signal; and
the negative resistance unit comprises a feedback capacitor and a parasitic capacitor, and the feedback capacitor and the parasitic capacitor collectively provide negative resistance for the resonant cavity.

2. The frequency multiplier according to claim 1, wherein the harmonic signal comprises a plurality of harmonic components, a frequency of each of the plurality of harmonic components is a multiple of the frequency of the fundamental frequency signal, and outputting the intrinsic signal by using the resonant cavity comprises:
performing, by the resonant cavity, resonant amplification on one of the plurality of harmonic components, to obtain the intrinsic signal.

3. The frequency multiplier according to claim 1, wherein the oscillator further comprises a first transistor and a second transistor, the first transistor and the second transistor are configured to receive the harmonic signal, a gate of the first transistor is coupled to a source of the second transistor by using a first capacitor, and a gate of the second transistor is coupled to a source of the first transistor by using a second capacitor.

4. The frequency multiplier according to claim 3, wherein the frequency multiplier further comprises an inductor, and the inductor is electrically connected between the harmonic generator and the oscillator.

5. The frequency multiplier according to claim 3, wherein there are two feedback capacitors, one of the two feedback capacitors is electrically connected between the source of the first transistor and a drain of the first transistor, and the other feedback capacitor is electrically connected between the source of the second transistor and a drain of the second transistor.

6. The frequency multiplier according to claim 5, wherein there are two parasitic capacitors, one of the two parasitic capacitors is electrically connected between the source of the first transistor and a ground, and the other parasitic capacitor is electrically connected between the source of the second transistor and the ground.

7. The frequency multiplier according to claim 4, wherein the harmonic generator comprises a third transistor, the fundamental frequency signal comprises a first fundamental frequency signal, the harmonic signal comprises a first harmonic signal, the third transistor is configured to generate the first harmonic signal based on the first fundamental frequency signal, the first harmonic signal comprises a plurality of harmonic components, and a frequency of each of the plurality of harmonic components is a multiple of the frequency of the fundamental frequency signal.

8. The frequency multiplier according to claim 7, wherein there are two inductors, the harmonic generator further comprises a fourth transistor, the fundamental frequency signal further comprises a second fundamental frequency signal, a gate of the third transistor receives the first fundamental frequency signal by using a third capacitor, a source of the third transistor is grounded, a drain of the third transistor is electrically connected to the source of the first transistor by using one of the inductors, a gate of the fourth transistor receives the second fundamental frequency signal by using the third capacitor, a source of the fourth transistor is grounded, the drain of the third transistor is electrically connected to the source of the second transistor by using the other inductor, and the first fundamental frequency signal and the second fundamental frequency signal are differential signals of each other.

9. The frequency multiplier according to claim 8, wherein when the third transistor is conducted, the gate of the second transistor receives the first harmonic signal by using the second capacitor and outputs the intrinsic signal by using the resonant cavity; and when the third transistor is cut off, the second transistor is cut off, and stops outputting the intrinsic signal by using the resonant cavity.

10. A wireless communication device, comprising a transmitter and/or a receiver, wherein the transmitter or the receiver or both comprise the frequency multiplier according to any one of claims 1 to 9 and a frequency mixer, and the frequency mixer is configured to perform frequency mixing on an input signal and the intrinsic signal that is output by the frequency multiplier.
